# FASCICULE DE BREVET EUROPEEN

(11) **EP 0 490 739 B1**
(45) Date de publication et mention de la délivrance du brevet: **18.06.1997**
(21) Numéro de dépôt: 91403307.1
(22) Date de dépôt: 06.12.1991
(51) Int. Cl.: H01L 25/065, H01L 21/60

(54) **Procédé et dispositif d'interconnexion de circuits intégrés en trois dimensions**
Verfahren und Anordnung zum Verbinden integrierter Schaltungen in drei Dimensionen
Interconnection method and device for three-dimensional integrated circuits

(30) Priorité: 11.12.1990 FR 9015473
(43) Date de publication de la demande: 17.06.1992
(73) Titulaire: THOMSON-CSF, 75008 Paris (FR)
(72) Inventeur: Leroy, Michel, F-92045 Paris la Défense (FR); Val, Christian, F-92045 Paris la Défense (FR)
(74) Mandataire: Benoit, Monique

(56) Documents cités:
- EP-A- 0 019 186
- FR-A- 2 645 681
- US-A- 3 746 934
- 3-D Interconnection for Ultra-Dense Multichip Modules, IEEE Trans. on Components, Hybrids and Manufacturing Tech., vol. 13, no.4, 1990.

## Description

La présente invention a pour objet un procédé et un dispositif pour l'interconnexion de pastilles semi-conductrices empilées, chacune des pastilles contenant un circuit intégré.

Il a déjà été proposé de réaliser des empilements de circuits intégrés, comme par exemple décrit dans le brevet américain n° 4.706.166. Selon cette réalisation, les pastilles sont disposées sur un circuit imprimé, accolées les unes aux autres perpendiculairement au circuit imprimé ; les plots de connexion de chacune des pastilles sont ramenés sur un même côté de la pastille ; ce côté est disposé sur le circuit imprimé et les connexions avec ce dernier y sont réalisées. Toutefois, cet arrangement présente notamment des limitations liées au nombre de plots qu'il est matériellement possible de disposer sur un seul côté d'une pastille semi-conductrice ; en outre, il est onéreux du fait que les pastilles ne sont pas standard (la disposition des plots doit être modifiée) ; enfin, les connexions ainsi réalisées sont peu accessibles et de plus non visibles, ce qui en limite l'utilisation.

La présente invention concerne un dispositif d'interconnexion de circuits intégrés empilés qui évite ces inconvénients et limitations par l'utilisation des faces de l'empilement comme surface d'interconnexion. Une telle utilisation des surfaces de l'empilement est connue de l'article "3-D Interconnection for Ultra-Dense Multichip Modules" paru dans IEEE Transactions on Components, Hybrids, and Manufacturing Technology, vol.13, n°4, de Décembre 1990.

L'invention a pour objet une réalisation optimisée des interconnexions, utilisant des rainures.

Plus précisément, l'invention a pour objet un procédé d'interconnexion de plaquettes semiconductrices tel que défini par la revendication 1, ainsi qu'un dispositif d'interconnexion de plaquettes semiconductrices tel que défini par la revendication 8.

D'autres objets, particularités et résultats de l'invention ressortiront de la description suivante, illustrée par les dessins annexés qui représentent :
- la figure 1, une vue en perspective éclatée d'un mode de réalisation de l'empilement de plaquettes semi-conductrices selon l'invention ;
- la figure 2, un exemple de plaquette insérée dans l'empilement de la figure précédente ;
- la figure 3, un mode de réalisation du procédé d'interconnexion d'empilement, qui ne constitue pas une étape de l'invention ;
- la figure 4, une vue en coupe fractionnaire d'un mode de réalisation pratique de l'empilement selon l'invention ;
- la figure 5, un mode de réalisation des connexions des plaquettes sur les faces de l'empilement, qui ne constitue pas une étape de l'invention ;
- les figures 6a et 6b, des détails de réalisation de la figure précédente ;
- la figure 7, un mode de réalisation du procédé selon l'invention ;
- la figure 8, une vue fractionnaire d'une étape du procédé de la figure précédente ;
- la figure 9, une variante de réalisation des connexions des plaquettes sur les faces de l'empilement selon l'invention.

Sur ces différentes figures, les mêmes références se rapportent aux mêmes éléments. En outre, pour la clarté des dessins, l'échelle réelle n'est pas respectée.

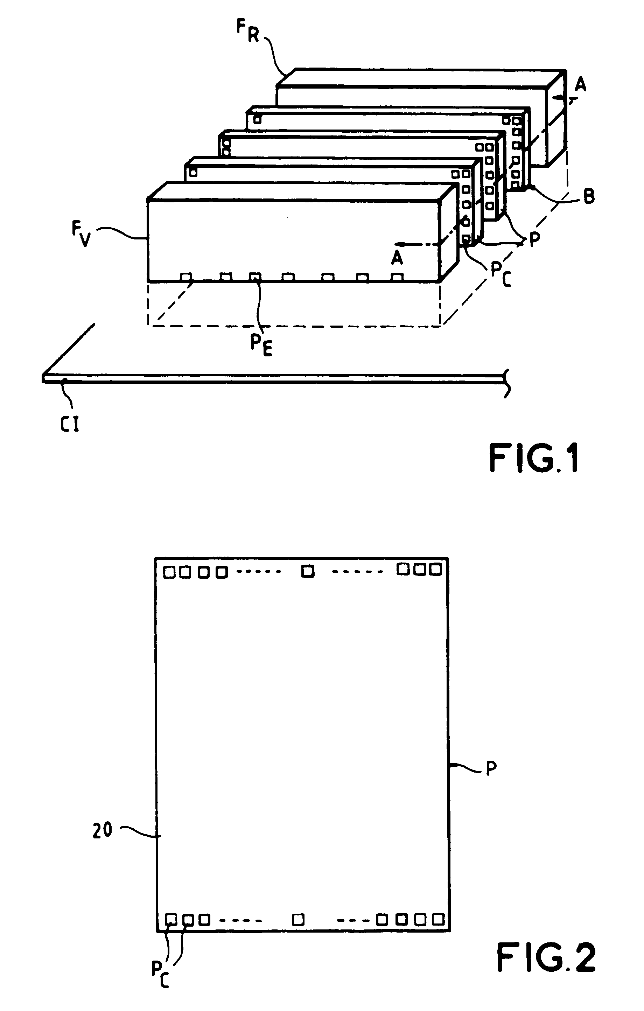

La figure 1 est donc une vue éclatée d'un empilement selon l'invention de plaquettes semi-conductrices.

Sur cette figure, on trouve donc une pluralité de plaquettes P (trois plaquettes sur le schéma) disposées parallèlement les unes aux autres. Les plaquettes P peuvent être des pastilles semi-conductrices ou un circuit imprimé, céramique ou époxy, comportant une ou plusieurs puces semi-conductrices. L'empilement est par exemple fermé par une première plaque isolante F_{V}, formant face avant et une deuxième plaque isolante F_{R}, formant face arrière.

La figure 2 représente, à titre d'exemple, une plaquette P de l'empilement de la figure précédente, constituée par une pastille semi-conductrice.

Celle-ci se compose d'une plaquette semi-conductrice 20 dans laquelle est réalisé un circuit intégré quelconque, une mémoire par exemple. A la surface de la plaquette P, apparaissent des plots P_{C}, disposés par exemple au voisinage de deux des bords de la plaquette, permettant la connexion électrique du circuit contenu dans la plaquette vers l'extérieur ; les plots P_{C} peuvent bien entendu être disposés autour des quatre côtés de la plaquette P, ou encore en un point quelconque de sa surface.

L'empilement de la figure 1 est, dans ce mode de réalisation, destiné à être disposé sur un substrat de circuit imprimé CI par l'intermédiaire de l'une de ses faces B, appelée base. Les faces avant et arrière F_{V} et F_{R}, par exemple, portent des plots P_{E} dits d'empilement, destinés à la connexion de l'empilement vers les autres circuits portés par le circuit imprimé CI. Ces plots d'empilement P_{E} sont disposés par exemple au voisinage de la base B.

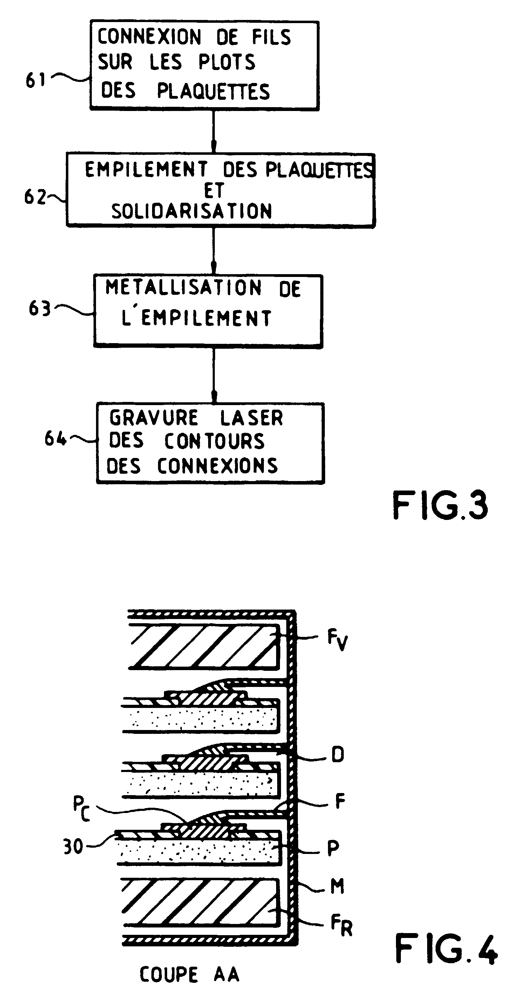

La figure 3 illustre un exemple de réalisation du procédé d'interconnexion d'empilement selon l'invention.

La première étape, repérée 61, consiste à relier électriquement les plots P_{C} des plaquettes P aux faces latérales de l'empilement. Cette étape est illustrée sur la figure 4, qui est une coupe selon le plan A-A de la figure 1.

Sur la figure 4, on retrouve la face avant F_{V}, la face arrière F_{R} et, entre ces deux faces, trois plaquettes P. Ainsi qu'il est connu, la surface de chacune de ces plaquettes est recouverte d'une couche d'isolant 30, sauf aux endroits des plots de connexion P_{C}.

Selon l'invention, on connecte un fil conducteur F, par exemple par soudure, sur chacun des plots P_{C} de chacune des plaquettes. Chacun des fils F est dirigé vers l'une des faces de l'empilement, selon les besoins de la connectique. Sur la figure 4 on a, à titre d'exemple, dirigé les fils F représentés vers la même face. Dans une variante de réalisation, les fils F peuvent être remplacés par des rubans conducteurs. Pour simplifier la description, on parlera ci-après uniquement de "fils conducteurs" ou de "conducteurs" F.

Lors de l'étape suivante (62, figure 3), on réalise l'empilement des plaquettes P. Dans une variante de réalisation, chacune des plaquettes P peut être, avant empilement, recouverte d'une goutte de matériau isolant de protection (silicone ou analogue), comme il est usuel pour la protection des pastilles semi-conductrices. On procède alors à la solidarisation de l'ensemble à l'aide d'un matériau isolant D, tel qu'une résine époxy. Pour la clarté de la figure 4, le matériau diélectrique D n'a pas été hachuré bien que vu en coupe. L'empilement est alors découpé ou poli de sorte que les fils F affleurent sur les faces de l'empilement.

L'étape suivante (63, figure 3), qui ne constitue pas une étape de l'invention, consiste à déposer une (ou plusieurs) couche M conductrice, métallique par exemple, sur l'ensemble des faces de l'empilement ainsi constitué.

L'étape suivante (64, figure 3), qui ne constitue pas une étape de l'invention, consiste à réaliser sur les faces latérales de l'empilement, à partir de la couche M, des connexions reliant les fils F entre eux et aux plots P_{E}.

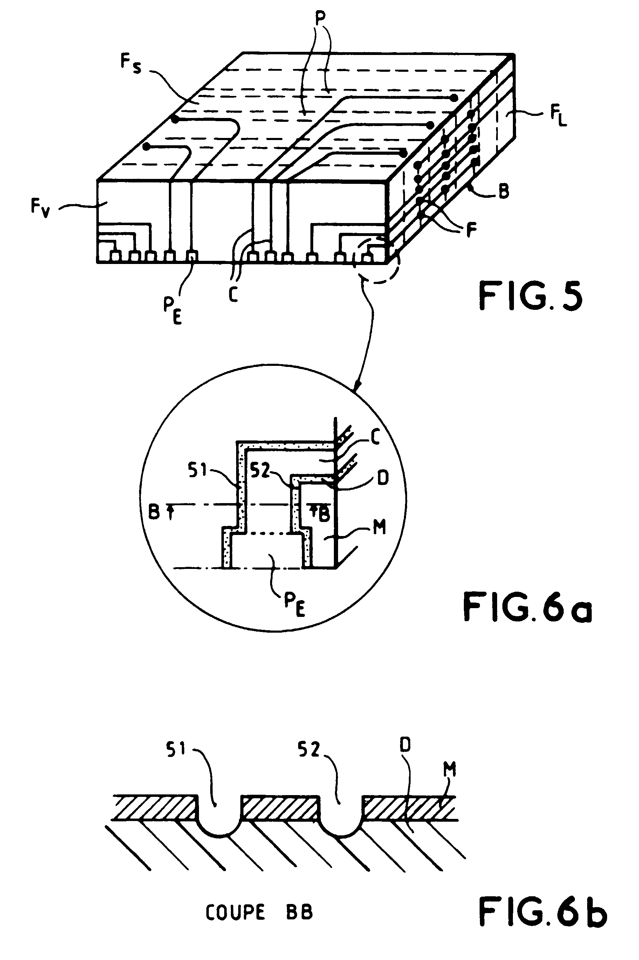

La figure 5 représente un empilement, qui ne constitue pas une étape de l'invention, sur lequel sont illustrés des exemples de connexions.

Sur cette figure, on retrouve l'empilement comportant la face avant F_{V}, la base B, la face opposée à la base (face supérieure) étant repérée F_{S} et les deux faces restantes F_{L} étant dites faces latérales . On voit les fils F affleurer sur une face latérale F_{L}. Ils sont à la fois interconnectés entre eux et reliés à des plots d'empilement P_{E} à l'aide de connexions C. On a représenté également, toujours à titre d'exemple, certains fils F affleurant sur la face supérieure F_{S} de l'empilement et reliés chacun à un plot d'empilement P_{E} distinct par une connexion C. A titre d'exemple encore, on a illustré des plots P_{E} sur la face F_{V} au voisinage de la base, mais il est entendu qu'ils peuvent occuper toute position sur les faces de l'empilement, sauf sur la base B.

Les figures 6a et 6b illustrent plus en détail l'étape 64 de réalisation des connexions C.

La figure 6a représente une vue fractionnaire et agrandie d'un morceau de l'empilement de la figure 5, où l'on voit une connexion C et un plot d'empilement P_{E}. La figure 6b est une vue en coupe selon un axe BB de la figure 6a.

Chacune des connexions C est formée par deux gravures 51 et 52, réalisées à l'aide d'un laser qui détruit localement la couche métallique M et fait apparaître la couche isolante D (pointillée sur la figure 6a pour la clarté du schéma), réalisant ainsi l'isolation électrique de la connexion C du reste de la couche M.

Les plots d'empilement P_{E} peuvent être avantageusement réalisés par la même technique de gravure laser, comme représenté sur la figure 6a.

Dans une variante de réalisation, les plots P_{E}, lorsqu'ils sont situés au voisinage de la base, se prolongent un peu sur cette dernière de façon à faciliter le montage et la connexion de l'empilement lorsque ceux-ci sont réalisés en surface, c'est-à-dire sans broches de connexion.

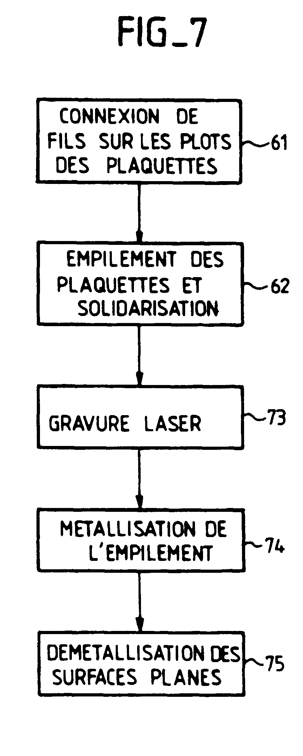

La figure 7 représente un mode de réalisation du procédé selon l'invention.

Les deux premières étapes du procédé, à savoir connexion de fils (ou rubans) sur les plots P_{C} des plaquettes P (étape 61), empilement et solidarisation des plaquettes (étape 62), sont identiques à ce qui a été décrit figure 3.

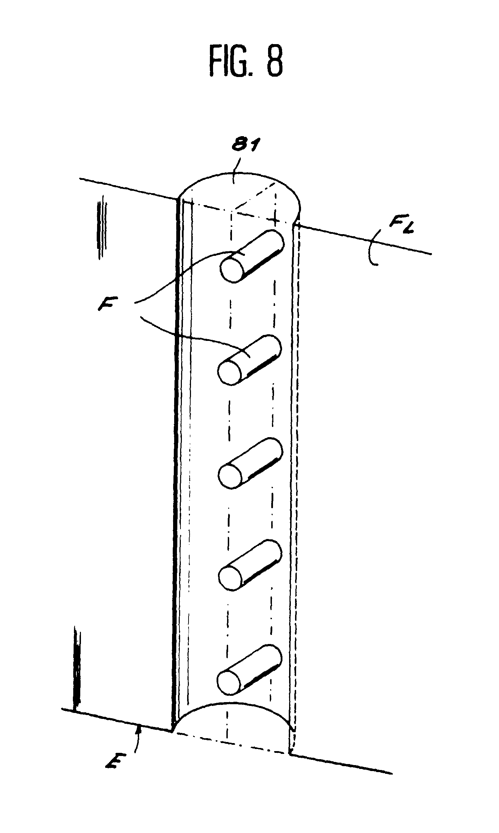

L'étape suivante (73) consiste, à réaliser une rainure dans l'empilement, au niveau où les fils F affleurent de sorte à dégager l'extrémité de ces derniers. Cette étape a été illustrée sur la figure 8 où on a reproduit à titre d'exemple un alignement de cinq fils F de la face F_{L} de la figure 5, la rainure étant repérée 81 et l'empilement, E. Ces rainures telles que 81 peuvent être réalisées par gravure laser dans le matériau isolant D (voir figure 4).

L'étape suivante (74) consiste à déposer une couche conductrice (métal par exemple) sur la totalité de l'empilement, c'est-à-dire faces de l'empilement, rainures (telles que 81) et fils F.

Enfin, la dernière étape (75) représentée figure 7 consiste à enlever la couche conductrice sur les surfaces planes de l'empilement, de sorte à ne la laisser subsister que dans les rainures telles que 81 où elle réalise la connexion recherchée. Cette dernière étape peut être réalisée par exemple par polissage ou à l'aide d'un laser.

On a représenté à titre d'exemple sur la figure 8 une rainure 81 droite reliant des fils F alignés, mais les rainures peuvent bien entendu affecter toute forme et relier tout fil F en fonction des connexions à réaliser.

Ce mode de réalisation a l'avantage, par rapport au précédent, de permettre un pas de connexion plus petit.

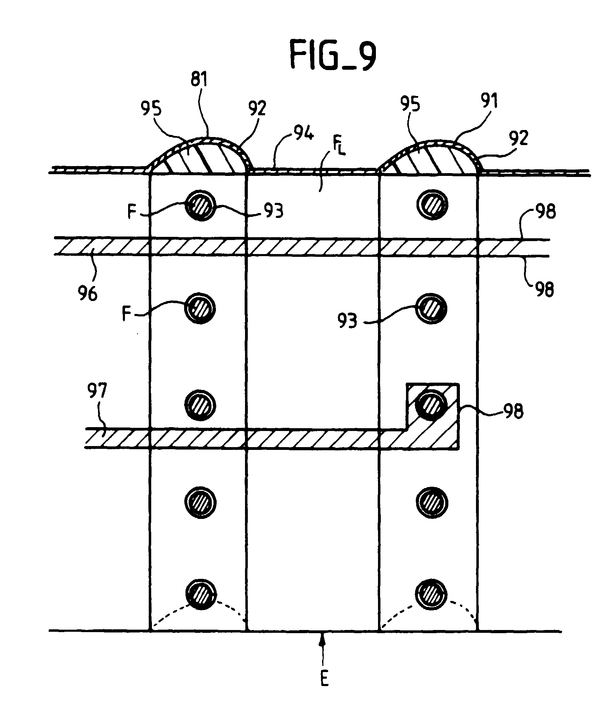

La figure 9 illustre une variante de réalisation des connexions des plaquettes sur les faces de l'empilement selon l'invention.

Sur cette figure, on a représenté l'empilement E tel qu'obtenu après le procédé décrit figure 7, c'est-à-dire présentant des rainures (81, 91) formées au niveau des fils F, les rainures et les fils F étant métallisés (couches 92 et 93, respectivement) et les faces planes F_{L} de l'empilement étant dé-métallisées.

Selon cette variante, on procède au dépôt d'un matériau isolant 95 dans chacune des rainures de sorte à les colmater. Si nécessaire, on nettoie ensuite la section des fils F de façon à permettre une connexion électrique ultérieure.

L'étape suivante consiste à métalliser à nouveau l'ensemble de l'empilement E puis à graver dans cette dernière couche conductrice les contours (98) des connexions (96, 97) à réaliser, de façon analogue à ce qui est décrit ci-dessus (étape 64 de la figure 3 en liaison avec les figures 6).

A titre d'exemple, on a représenté figure 9 deux connexions seulement, qu'on a hachuré pour la lisibilité de la figure, l'une (97) connectant l'un des fils F de la rainure 91 avec d'autres plots non représentés et l'autre (96) traversant les deux rainures (91, 81 ), sans connexion électrique.

Cette variante permet ainsi de réaliser simplement des croisements de connexions à la surface de l'empilement.

Il apparaît qu'on a ainsi réalisé un empilement de plaquettes contenant des circuits intégrés qui peuvent être identiques entre eux ou non, tant sur le plan électrique que sur le plan de la géométrie de la plaquette. Ces plaquettes sont interconnectées entre elles par les faces de l'empilement, sans nécessiter de passage par le circuit imprimé, ce qui permet de diminuer le nombre de plots d'empilement P_{E} ou, inversement, d'augmenter le nombre ou la complexité des plaquettes empilables.

Egalement, le fait de relier les plots P_{C} des plaquettes aux faces de l'empilement par des fils permet de faire émerger ces fils sur n'importe quelle face (hors la base). Dans une variante de réalisation, les fils F peuvent être individuellement isolés. De plus, la connexion au circuit imprimé se fait par les plots d'empilement P_{E} qui peuvent être placés sur n'importe laquelle des faces F_{V}, F_{R} ou F_{L} et qui, de ce fait, peuvent être nombreux. Enfin, les connexions plots P_{E}-circuit imprimé sont accessibles et visibles, ce qui en diminue le coût et autorise certaines applications, militaires notamment.

La description faite ci-dessus l'a été bien entendu à titre d'exemple non limitatif. C'est ainsi par exemple que l'empilement a été décrit tel que les plaquettes soient perpendiculaires au circuit imprimé mais que l'empilement peut être réalisé dans l'autre direction et les plaquettes être parallèles à ce circuit imprimé. Egalement, les plots d'empilement P_{E} ont été illustrés sur les faces F_{V} et F_{R}, mais peuvent être disposés sur n'importe laquelle des faces de l'empilement et n'importe où sur ces faces, selon l'application ; en effet, lorsque l'empilement est, comme représenté figure 1, destiné à être disposé sur un circuit imprimé, on peut disposer les plots P_{E} sur n'importe quelle face, sauf la base, mais de préférence au voisinage des arêtes de la base ; mais il est également possible d'interconnecter deux (ou plus) empilements entre eux, auquel cas les plots P_{E} peuvent occuper n'importe quelle position. De la même manière, on a décrit un procédé de réalisation des connexions C par laser utilisant une technique de gravure mais on peut utiliser également une technique de dépôt à l'aide d'un laser ; à cet effet, on place l'empilement dans une vapeur organométallique et on chauffe à l'aide du laser la zone où on désire former la connexion ; l'échauffement provoque la décomposition de la vapeur et le dépôt du métal à l'endroit voulu ; le dépôt d'une couche isolante locale se fait, en tant que besoin, de façon analogue en adaptant la composition de la vapeur. Enfin, on a représenté une seule couche de connexions C sur l'empilement, mais on peut en disposer plusieurs (isolées entre elles), par exemple par la technique du dépôt laser décrite ci-dessus, de sorte par exemple à permettre les croisements de connexions.

## Revendications

1. Procédé d'interconnexion de pastilles semi-conductrices (P), chacune contenant au moins un circuit intégré et comportant des plots de connexion (P_{C}), le procédé comportant successivement les étapes suivantes :
- connexion (61) d'un conducteur (F) sur chacun des plots (P_{C}) des pastilles ;
- empilement (62) des pastilles et solidarisation de ces dernières et des conducteurs (F) dans un matériau isolant (D), de sorte que les conducteurs affleurent les faces de l'empilement ;
- formation de connexions électriques entre les conducteurs (F) sur les faces de l'empilement à l'aide d'un laser, certaines de ces connexions au moins étant disposées sur au moins deux faces de l'empilement,
le procédé étant caractérisé par le fait que l'étape de formation de connexions électriques entre les conducteurs sur les faces de l'empilement consiste à
- former une rainure (81) dans l'empilement au niveau où les conducteurs (F) affleurent, de sorte à dégager l'extrémité de ces derniers ;
- déposer une couche conductrice (92) destinée à subsister dans les seules rainures.

2. Procédé selon la revendication 1, caractérisé par le fait que le dépôt d'une couche conductrice s'effectue sur l'ensemble de l'empilement, la couche conductrice étant ultérieurement retirée des surfaces planes de l'empilement.

3. Procédé selon l'une des revendications précédentes, caractérisé par le fait que la couche conductrice est métallique.

4. Procédé selon la revendication 1, caractérisé par le fait que l'étape de formation de connexions électriques consiste à disposer l'empilement dans une vapeur organométallique puis à chauffer par laser localement les surfaces destinées à former les connexions, y provoquant un dépôt métallique.

5. Procédé selon l'une des revendications précédentes, caractérisé par le fait que lors de l'étape de formation de connexions électriques sont formés en outre des plots dits d'empilement (P_{E}), destinés à la connexion de l'empilement avec des circuits extérieurs, et que les connexions électriques relient entre eux conducteurs (F) et plots d'empilement (P_{E}).

6. Procédé selon l'une des revendications précédentes, caractérisé par le fait qu'il comporte en outre, avant empilement, une étape de protection de chacune des plaquettes par recouvrement de la plaquette par une goutte de matériau isolant de protection.

7. Procédé selon l'une des revendications précédentes, caractérisé par le fait qu'il comporte en outre, après le dépôt d'une couche conductrice et successivement, une première étape de dépôt d'une couche isolante sur au moins les rainures, puis une deuxième étape de formation de connexions électriques selon une deuxième couche.

8. Dispositif d'interconnexion de plaquettes semiconductrices (P), chacune contenant au moins un circuit intégré et comportant des plots de connexion (P_{C}), les plaquettes (P) étant rendues solidaires les unes des autres à l'aide d'un matériau isolant (D) pour former un empilement, les plots de connexion (P_{C}) des plaquettes étant reliés électriquement par des conducteurs (F) à certaines au moins des faces de l'empilement, la liaison électrique des conducteurs (F) entre eux étant effectuée par des connexions (C) réalisées sur les faces de l'empilement, certaines de ces connexions au moins étant disposées sur au moins deux faces de l'empilement, le dispositif étant caractérisé par le fait que ces connexions sont constituées par une couche conductrice (92) disposée dans une rainure (81) reliant les conducteurs entre eux.

9. Dispositif selon la revendication 8, caractérisé par le fait que l'une au moins des faces de l'empilement, dite base (B), ne comporte pas de conducteurs (F), que l'empilement comporte des plots d'empilement (P_{E}) formés sur sa surface au voisinage de la base, destinés à la connexion de l'empilement avec des circuits extérieurs, et que les connexions (C) assurent en outre la liaison des conducteurs avec les plots d'empilement.

10. Dispositif selon l'une des revendications 8 ou 9, caractérisé par le fait que les conducteurs (F) sont des fils.

11. Dispositif selon l'une des revendications 8 ou 9, caractérisé par le fait que les conducteurs (F) sont des rubans.

12. Dispositif selon l'une des revendications 10 ou 11, caractérisé par le fait que les conducteurs (F) sont individuellement isolés.

## Patentansprüche

1. Verbindungsverfahren für Halbleiterplättchen (P), die je mindestens eine integrierte Schaltung enthalten sowie Verbindungspunkte (P_{C}), wobei das Verfahren folgende Schritte enthält:
- den Anschluß (61) eines Leiters (F) an jeden der Verbindungspunkte (P_{C}) der Plättchen,
- die Stapelung (62) der Plättchen und den Zusammenbau dieser Plättchen und der Leiter (F) in einem isolierenden Material (D) derart, daß die Leiter an den Seiten des Stapels zutagetreten,
- Herstellung der elektrischen Verbindungen zwischen den Leitern (F) auf den Seiten des Stapels mit Hilfe eines Lasers, wobei zumindest bestimmte Verbindungen auf mindestens zwei Seiten des Stapels liegen,
dadurch gekennzeichnet, daß es zur Herstellung der elektrischen Verbindungen zwischen den Leitern auf den Seiten des Stapels folgende Schritte aufweist:
- Bildung einer Nut (81) im Stapel an der Stelle, an der die Leiter (F) zutagetreten, so daß das Ende dieser Leiter freigelegt wird,
- Aufbringen einer leitenden Schicht (92), die nur in den Nuten verbleiben soll.

2. Verfahren nach Anspruch 1, dadurch gekennzeichnet, daß das Aufbringen einer leitenden Schicht den ganzen Stapel betrifft und daß die leitende Schicht dann von den ebenen Oberflächen des Stapels entfernt wird.

3. Verfahren nach einem der vorhergehenden Ansprüche, dadurch gekennzeichnet, daß die leitende Schicht eine Metallschicht ist.

4. Verfahren nach Anspruch 1, dadurch gekennzeichnet, daß der Schritt der Bildung von elektrischen Verbindungen darin besteht, den Stapel in einen organometallischen Dampf zu bringen und dann durch einen Laser lokal die Flächen zu erwärmen, die die Verbindungen bilden sollen, so daß dort Metall abgeschieden wird.

5. Verfahren nach einem der vorhergehenden Ansprüche, dadurch gekennzeichnet, daß bei der Herstellung der elektrischen Verbindungen außerdem sogenannte Stapelanschlußpunkte (P_{E}) gebildet werden, die den Anschluß des Stapels an äußere Schaltungen gewährleisten sollen, und daß die elektrischen Verbindungen die Leiter (F) und die Stapelanschlußpunkte (P_{E}) miteinander verbinden.

6. Verfahren nach einem der vorhergehenden Ansprüche, dadurch gekennzeichnet, daß außerdem vor dem Stapeln jedes der Plättchen mit einem Tropfen eines isolierenden Schutzmaterials bedeckt wird.

7. Verfahren nach einem der vorhergehenden Ansprüche, dadurch gekennzeichnet, daß weiter nach dem Aufbringen einer leitenden Schicht eine isolierende Schicht auf mindestens die Nuten aufgebracht wird und daß dann elektrische Verbindungen in einer zweiten Schicht hergestellt werden.

8. Vorrichtung zur Verbindung von Halbleiterplättchen (P), die je mindestens eine integrierte Schaltung sowie Verbindungspunkte (P_{C}) besitzen, wobei die Plättchen (P) mit Hilfe eines isolierenden Materials (D) zu einem Stapel zusammengefügt sind und die Verbindungspunkte (P_{C}) der Plättchen elektrisch über Leiter (F) an mindestens bestimmte Stapelseiten geführt sind, wobei die elektrische Verbindung der Leiter (F) untereinander durch Verbindungen (C) erfolgt, die an den Seiten des Stapels hergestellt sind und mindestens bestimmte dieser Verbindungen auf mindestens zwei Seiten des Stapels verlaufen, dadurch gekennzeichnet, daß diese Verbindungen von einer leitenden Schicht (92) gebildet werden, die in einer Nut (81) liegt und die Leiter miteinander verbindet.

9. Vorrichtung nach Anspruch 8, dadurch gekennzeichnet, daß mindestens eine der Seiten des Stapels, Basis (B) genannt, keine Leiter (F) enthält, daß der Stapel Stapelanschlußpunkte (P_{E}) enthält, die auf seiner Oberfläche in der Nähe der Basis ausgebildet sind und zum Anschluß des Stapels an äußere Schaltungen bestimmt sind, und daß die Verbindungen (C) außerdem die Leiter an die Stapelanschlußpunkte anschließt.

10. Vorrichtung nach einem der Ansprüche 8 oder 9, dadurch gekennzeichnet, daß die Leiter (F) Drähte sind.

11. Vorrichtung nach einem der Ansprüche 8 oder 9, dadurch gekennzeichnet, daß die Leiter (F) Bänder sind.

12. Vorrichtung nach einem der Ansprüche 10 oder 11, dadurch gekennzeichnet, daß die Leiter (F) einzeln isoliert sind.

## Claims

1. Method for interconnecting semiconductor chips (P), each containing at least one integrated circuit and including bonding pads (P_{C}), the method successively including the following steps:
- connecting (61) a conductor (F) onto each of the pads (P_{C}) of the chips;
- stacking (62) the chips and fixing them and the conductors (F) in an insulator (D) so that the conductors meet the faces of the stack;
- forming electrical connections between the conductors (F) on the faces of the stack using a laser, at least some of these connections being arranged on at least two faces of the stack,
the method being characterized in that the step of forming electrical connections between the conductors on the faces of the stack consists in:
- forming a groove (81) in the stack at the level where the conductors (F) meet the surface, so as to expose the ends of these conductors;
- depositing a conductive layer (92) intended to remain in the grooves alone.

2. Method according to Claim 1, characterized in that the deposition of a conductive layer takes place over the entire stack, the conductive layer being subsequently withdrawn from the plane surfaces of the stack.

3. Method according to one of the preceding claims, characterized in that the conductive layer is metallic.

4. Method according to Claim 1, characterized in that the step of forming electrical connections consists in arranging the stack in an organometallic vapour, then in locally laser-heating the surfaces intended to form the connections, causing metal deposition thereof.

5. Method according to one of the preceding claims, characterized in that, during the step of forming electrical connections, so-called stack pads (P_{E}) are also formed which are intended for connecting the stack to external circuits, and in that the electrical connections connect together the conductors (F) and the stack pads (P_{E}).

6. Method according to one of the preceding claims, characterized in that it furthermore includes, before stacking, a step of protecting each of the wafers by covering the wafer with a drop of protective insulator.

7. Method according to one of the preceding claims, characterized in that it furthermore includes, successively after the deposition of a conductive layer, a first step of depositing an insulating layer at least on the grooves, then a second step of forming electrical connections in a second layer.

8. Device for interconnecting semiconductor wafers (P), each containing at least an integrated circuit and including bonding pads (P_{C}), the wafers (P) being fixed to one another using an insulator (D) in order to form a stack, the bonding pads (P_{C}) of the wafers being electrically connected by conductors (F) at at least some of the faces of the stack, the conductors (F) being electrically connected together by connections (C) produced on the faces of the stack, at least some of these connections being arranged on at least two faces of the stack, the device being characterized in that these connections consist of a conductive layer (92) arranged in a groove (81) joining the conductors together.

9. Device according to Claim 8, characterized in that at least one of the faces of the stack, referred to as the base (B), does not include conductors (F), in that the stack includes stack pads (P_{E}) formed on its surface next to the base, which are intended for connecting the stacks to external circuits, and in that the connections (C) furthermore connect the conductors to the stack pads.

10. Device according to one of Claims 8 and 9, characterized in that the conductors (F) are wires.

11. Device according to one of Claims 8 and 9, characterized in that the conductors (F) are strips.

12. Device according to one of Claims 10 and 11, characterized in that the conductors (F) are individually insulated.
